Europäisches Patentamt

European Patent Office

Office européen des brevets

(11) Veröffentlichungsnummer : **0 018 310**

**B1**

(12) **EUROPÄISCHE PATENTSCHRIFT**

(45) Veröffentlichungstag der Patentschrift :
05.10.83

(21) Anmeldenummer : 80730024.9

(22) Anmeldetag : 18.03.80

(51) Int. Cl.³ : **G 01 R 13/40, G 02 F 1/133**

(54) Schaltungsanordnung zur Überwachung des Verhältnisses der Werte zweier elektrischer Messignale.

(30) Priorität : 12.04.79 DE 2915703

(43) Veröffentlichungstag der Anmeldung :
29.10.80 Patentblatt 80/22

(45) Bekanntmachung des Hinweises auf die Patenterteilung : 05.10.83 Patentblatt 83/40

(84) Benannte Vertragsstaaten :
AT BE CH FR NL SE

(56) Entgegenhaltungen :
DE A 1 917 074
DE A 2 734 097
GB A 1 220 068

(73) Patentinhaber : **SIEMENS AKTIENGESELLSCHAFT**
**Berlin und München Wittelsbacherplatz 2**
**D-8000 München 2 (DE)**

(72) Erfinder : **Daubitz, Wolfgang, Dipl.-Ing.**
**Kyllmannstrasse 2**
**D-1000 Berlin 45 (DE)**

Schaltungsanordnung zur Überwachung des Verhältnisses der Werte zweier elektrischer Meßsignale

Die Erfindung betrifft eine Schaltungsanordnung zur Überwachung des Verhältnisses der Werte zweier elektrischer Meßsignale auf einen vorgegebenen höchstzulässigen Grenzwert mit einer Grenzwertstufe, der eingangsseitig eine mit den zwei Meßsignalen direkt beaufschlagte Bewertungsschaltung vorgeordnet ist.

Es ist bekannt (Buch « Elektrische Meßtechnik », M. Stöckl und K. H. Winterling, 1978, Seite 121, Abb. 121.1b), die Überwachung der Werte zweier elektrischer Meßsignale auf einen vorgegebenen höchstzulässigen Grenzwert ihres Verhältnisses zueinander mit Hilfe einer Komparatorschaltung vorzunehmen. Die Komparatorschaltung enthält eine mit Widerständen aufgebaute Bewertungsschaltung und eine Grenzwertstufe. Die Festlegung des höchstzulässigen Grenzwertes erfolgt hierbei durch entsprechende Bemessungen der Widerstände der Bewertungsschaltung. Die Bemessung und Anordnung der Widerstände führt jedoch dazu, daß die Grenzwertstufe bei Überschreiten des höchstzulässigen Grenzwertes der Verhältnisse der Werte der elektrischen Meßsignale zueinander nur dann anspricht, wenn an einem Eingang der Bewertungsschaltung stets das jeweils größere Meßsignal anliegt. Die bekannte Komparatorschaltung ist demzufolge in ihrer Anwendbarkeit begrenzt.

Es ist ferner eine Einrichtung (DE-A-2734097) zur Überwachung des Verhältnisses zweier Spannungen bekannt, die u. a. ein Summiernetzwerk aufweist, dem eingangsseitig die beiden Spannungen zugeführt werden, deren Verhältnis überwacht werden soll. Diese Einrichtung enthält ferner einen Differenzverstärker, der einerseits eingangsseitig mit einer der beiden Spannungen beaufschlagt ist und an dem andererseits eingangsseitig eine Hilfsspannung liegt, die mittels eines differenzbildenden Netzwerkes aus der anderen Spannung und der Ausgangsspannung eines Kommutators gebildet ist ; der Kommutator ist sowohl dem Differenzverstärker als auch dem Summiernetzwerk nachgeordnet. Mit der beschriebenen Einrichtung läßt sich das Verhältnis auf einen kritischen Wert überwachen, wobei der kritische Wert durch eine mit dem Summiernetzwerk vornehmbare Bewertung festlegbar ist. Nur bei einem bestimmten Verhältnis der Spannungen liefert die bekannte Einrichtung ein Ausgangssignal. Vertauschen die Spannungen ihre Beträge, dann gibt die bekannte Einrichtung kein Ausgangssignal ab.

Es sind schließlich Einrichtungen bekannt (DE-A-19 17 074 und GB-A-12 20 068), mit denen ein größtes von mehreren Eingangssignalen auswählbar ist, jedoch handelt es sich dabei nicht um Schaltungsanordnungen zur Überwachung der Werte zweier elektrischer Meßsignale auf ein vorgegebenes höchstzulässiges Verhältnis.

Der Erfindung liegt die Aufgabe zugrunde, eine Schaltungsanordnung zur Überwachung der Werte zweier elektrischer Meßsignale auf einen vorgegebenen höchstzulässigen Grenzwert ihres Verhältnisses zueinander vorzuschlagen, bei der die Überwachung unabhängig davon erfolgt, an welchem Eingang der Bewertungsschaltung das jeweils größere Meßsignal ansteht.

Zur Lösung dieser Aufgabe enthält die Schaltungsanordnung ein Übertragungsnetzwerk, dem eingangsseitig die zwei Meßsignale zugeführt werden und das auf seinen Ausgang nur dasjenige Meßsignal überträgt, welches den jeweils größeren Wert aufweist, und die Bewertungsschaltung ist eingangsseitig auch mit dem Ausgang des Übertragungsnetzwerkes verbunden und bewertet die Meßsignale und das Signal am Ausgang des Übertragungsnetzwerkes derart, daß bei dem vorgegebenen höchstzulässigen Grenzwert des Verhältnisses der Werte der Meßsignale die Summe aller bewerteter Signale eine vorbestimmte Größe hat.

Ein Vorteil der erfindungsgemäßen Schaltungsanordnung besteht darin, daß zwei elektrische Meßsignale auf einen höchstzulässigen Grenzwert ihres Verhältnisses zueinander überwacht werden können, ohne daß stets das eine Meßsignal das größere Meßsignal sein muß. Ausgehend vom Wert eines Meßsignals lassen sich somit die Verhältnisse der Werte der Meßsignale sowohl bei Verhältnissen größer 1 als auch kleiner 1 überwachen. Unabhängig also davon, welches Meßsignal das jeweils größere ist, läßt sich der höchstzulässige Grenzwert feststellen. Ein weiterer Vorteil ist, daß dies lediglich durch das zusätzliche Übertragungsnetzwerk erreicht wird, dem eingangsseitig die zwei Meßsignale zugeführt werden und das auf seinen Ausgang nur dasjenige Meßsignal überträgt, welches den jeweils größeren Wert aufweist.

Die erfindungsgemäße Schaltungsanordnung ist weiterhin insofern vorteilhaft, als sie lediglich hinsichtlich der Bewertung des am Ausgang des Übertragungsnetzwerkes anstehenden Signals erweitert werden muß, was mit relativ geringem zusätzlichem Schaltungsaufwand erreichbar ist.

Bei der erfindungsgemäßen Schaltungsanordnung liegt vorteilhafterweise der Eingang der Grenzwertstufe über einen Widerstand der Bewertungsschaltung an dem einen Meßsignal und über einen zweiten Widerstand der Bewertungsschaltung an dem zweiten Meßsignal und ist über einen weiteren Widerstand der Bewertungsschaltung mit dem Ausgang des Übertragungsnetzwerkes verbunden ; der weitere Widerstand ist gemäß der Gleichung :

$$R3 = m/1 + m \cdot R$$

bemessen, wobei R den Wert sowohl des ersten als auch des zweiten Widerstandes und m den vorgegebenen höchstzulässigen Grenzwert des Verhältnisses der Werte des jeweils größeren Meßsignals zu dem jeweils kleineren Meßsignal bezeichnet. Die vorbestimmte Größe der Summe aller bewerteten Signale ist Null. Der Vorteil besteht vor allem darin, daß als Grenzwertstufe ein üblicher Operationsverstärker verwendet werden kann ; dies ist darauf zurückzuführen, daß durch die Bemessung der einzelnen Widerstände der Bewertungsschaltung bei dem vorgegebenen höchstzulässigen Grenzwert des Verhältnisses der Werte der Meßsignale die Summe aller bewerteten Meßsignale Null ist. Ein weiterer Vorteil besteht darin, daß die Bewertungsschaltung im Vergleich zu der Bewertungsschaltung in der eingangs behandelten, bekannten Schaltungsanordnung lediglich mit einem weiteren Widerstand zur Bewertung des Signals am Ausgang des Übertragungsnetzwerkes erweitert ist.

Es hat sich ferner als vorteilhaft erwiesen, wenn dem weiteren Widerstand der Bewertungsschaltung eine Reihenschaltung von einem Hilfswiderstand und einer Schalteinrichtung parallel liegt, wobei der Steuereingang der Schalteinrichtung mit dem Ausgang der Grenzwertstufe verbunden ist. Durch die Reihenschaltung ist es möglich, die Bewertung des Signals am Ausgang des Übertragungsnetzwerkes zu verändern und somit eine geringfügige Verminderung des höchstzulässigen Grenzwertes zu erreichen. Infolge der Steuerung der Schalteinrichtung durch das Signal am Ausgang der Grenzwertstufe wird Veränderung des Grenzwertes erst nach dem Ansprechen der Grenzwertstufe wirksam, so daß auch bei nachfolgender Änderung der Meßsignale mit einem den vorgegebenen Grenzwert geringfügig unterschreitenden Verhältnis ihrer Werte das Signal am Ausgang der Grenzwertstufe stabilisiert ist.

In schaltungstechnisch vorteilhafter Weise ist bei der erfindungsgemäßen Schaltungsanordnung vorgesehen, die Schalteinrichtung mit einem Transistor, vorzugsweise mit einem Feldeffekttransistor, zu versehen. Der mögliche Einsatz elektromechanischer Schalteinrichtungen, die einen höheren Leistungsbedarf und größere Verschleißerscheinungen aufweisen, kann damit vermieden werden.

Für den Aufbau des Übertragungsnetzwerkes ist es günstig, im Übertragungsnetzwerk für jedes Meßsignal einen Operationsverstärker vorzusehen, die gleich ausgebildet sind ; auch die Rückkopplungsnetzwerke der Operationsverstärker, die mit ihren Ausgängen zusammengeschaltet sind, sind in gleicher Weise ausgeführt. Durch den gleichen Aufbau der für jedes Meßsignal vorgesehenen Operationsverstärker kann die Schaltungsanordnung in einfacher Weise zur Überwachung beliebig vieler Meßsignale erweitert werden, ohne komplizierte Schaltungsänderungen oder Berechnungen vornehmen zu müssen.

Zur Erläuterung der Erfindung ist in

Fig. 1 ein Blockschaltbild der erfindungsgemäßen Schaltungsanordnung und in

Fig. 2 der Schaltungsaufbau der erfindungsgemäßen Schaltungsanordnung nach Fig. 1 dargestellt.

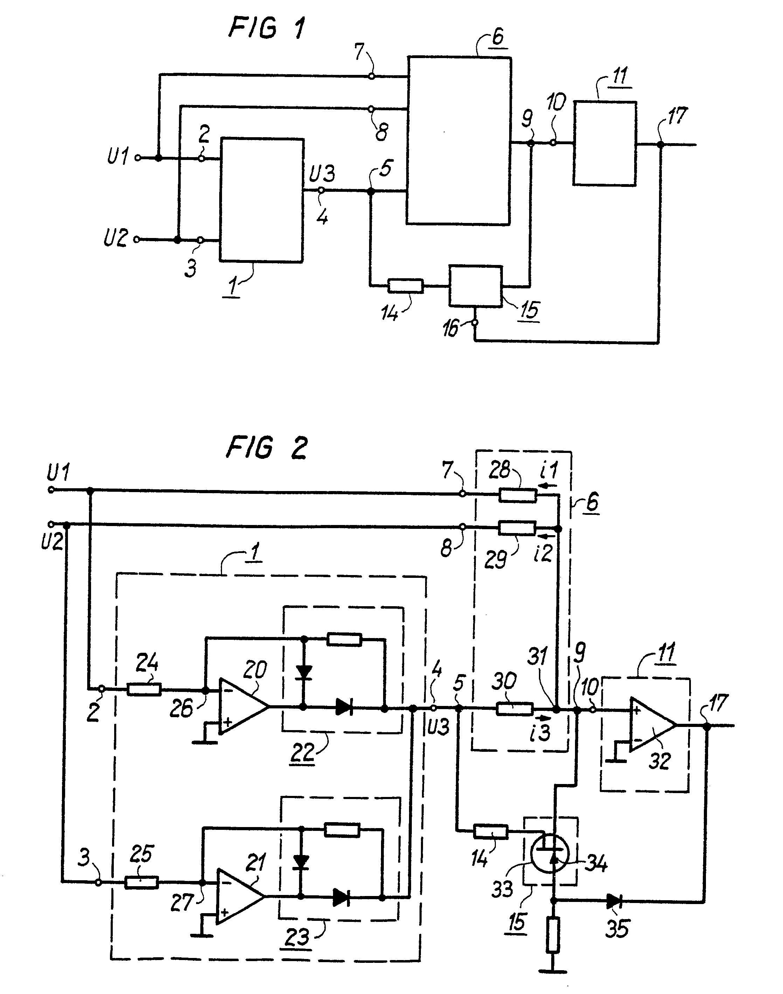

Das Ausführungsbeispiel nach Fig. 1 enthält ein Übertragungsnetzwerk 1, dem an Eingängen 2 und 3 Meßsignale U1 und U2 zugeführt werden. Am Ausgang 4 des Übertragungsnetzwerkes 1 liegt ein Signal U3. Der Ausgang 4 ist mit einem Eingang 5 einer Bewertungsschaltung 6 verbunden ; den weiteren Eingängen 7 und 8 der Bewertungsschaltung 6 werden die Meßsignale U1 und U2 zugeführt. Am Ausgang 9 der Bewertungsschaltung 6 ist ein Eingang 10 einer Grenzwertstufe 11 angeschlossen. Mit dem Eingang 5 der Bewertungsschaltung 6 und ihrem Ausgang 9 ist eine Reihenschaltung von einem Hilfswiderstand 14 und einer Schalteinrichtung 15 verbunden, wobei ein Steuereingang 16 der Schalteinrichtung 15 mit einem Ausgang 17 der Grenzwertstufe 11 in Verbindung steht.

Bei dem Schaltungsaufbau der erfindungsgemäßen Schaltungsanordnung nach Fig. 2 bilden gleich ausgeführte Operationsverstärker 20 und 21 mit gleichartig aufgebauten Rückkopplungsnetzwerken 22 und 23 das Übertragungsnetzwerk 1. Über Widerstände 24 und 25 sind die invertierenden Eingänge 26 und 27 der Operationsverstärker 20 und 21 mit den Eingängen 2 und 3 des Übertragungsnetzwerkes 1 verbunden. Die Rückkopplungsnetzwerke 22 und 23, die jeweils aus einer Dioden-Widerstandskombination bestehen, sind am Ausgang 4 des Übertragungsnetzwerkes 1 zusammengeschaltet.

Die Bewertungsschaltung.6 enthält einen Widerstand 28, über den der Eingang 10 der Grenzwertstufe an dem einen Meßsignal U1 liegt ; über einen zweiten Widerstand 29 erfolgt der Anschluß des Eingangs 10 an das zweite Meßsignal U2. Über einen weiteren Widerstand 30 ist der Eingang 10 mit dem Ausgang 4 des Übertragungsnetzwerkes verbunden. Auf diese Weise ist in der Bewertungsschaltung 6 ein Summationspunkt 31 gebildet.

In der zwischen dem Eingang 5 und dem Ausgang 9 der Bewertungsschaltung 6 liegenden Reihenschaltung des Hilfswiderstandes 14 und der Schalteinrichtung 15 bildet ein Feldeffekttransistor 33 die Schalteinrichtung, wobei der Gate-Anschluß 34 des Feldeffekttransistors 33 über eine Diode 35 mit dem Ausgang 17 der Grenzwertstufe 11 verbunden ist.

Anhand der Fig. 2 wird die Funktionsweise der erfindungsgemäßen Schaltungsanordnung erläutert.

An den invertierenden Eingängen 26 und 27 der Operationsverstärker 20 und 21 liegen die Meßsignale U1 und U2, die Gleichgrößen mit veränderlichen Werten darstellen und negatives Vorzeichen haben. Am gemeinsamen Ausgang 4 der beiden zusammengeschalteten Rückkopplungsnetzwerke 22 und 23 wird aus den Meßsignale U1 und U2 das Signal U3 gebildet, welches in seinem Wert den jeweils größeren der beiden Meßsignale U1 und U2 entspricht, jedoch positives Vorzeichen hat. Das jeweils kleinere Meßsignal wird nicht übertragen, da wegen der zusammengeschalteten Rückkopplungsnetzwerke am Eingang desjenigen Operationsverstärkers, an dessen Eingang das jeweils kleinere Meßsignal anliegt, ein positives Restsignal verbleibt, das diesen Operationsverstärker in den Sperrbereich treibt und dadurch für das jeweils kleinere Meßsignal sperrt.

Die Widerstände 28, 29 und 30 der Bewertungsschaltung 6 bewerten die Signale U1, U2 und U3 derart, daß am Summationspunkt 31 für den Fall, daß das Verhältnis der Werte der beiden Meßsignale U1 und U2 einen vorgegebenen höchstzulässigen Grenzwert hat, der Wert Null erscheint und somit die nachfolgende Grenzwertstufe 11 gerade noch nicht anspricht.

Diese Bedingung ist erfüllt, wenn die Summe der Ströme i1, i2 und i3 (vgl. Fig. 2), die die Widerstände der Bewertungsschaltung 6 durchfließen, folgende Gleichung erfüllt

$$i1 + i2 + i3 = 0. \qquad (1)$$

Dies entspricht folgender Gleichung

$$U1/R1 + U2/R2 = - U3/R3, \qquad (2)$$

wobei R1 den Wert des einen Widerstandes 28, R2 den Wert des zweiten Widerstandes 29 und R3 den Wert des weiteren Widerstandes 30 bezeichnet.

Bezeichnet man den höchstzulässigen Grenzwert des Verhältnisses der Werte des jeweils größeren Meßsignals zum jeweils kleineren mit m und nimmt man beispielsweise an, daß U1 das größere Meßsignal ist, dann ergibt sich folgende Gleichung

$$m = U1/U2. \qquad (3)$$

Ferner ergibt sich wegen des Übertragungsnetzwerkes 1 folgende Beziehung

$$U3 = - U1. \qquad (4)$$

Unter der Annahme, daß der Wert R1 gleich dem Wert R2 ist, werden beide Widerstandswerte fortan mit R bezeichnet, und es ergibt sich aus den Gleichungen (2), (3) und (4) für R3 folgende Beziehung

$$R3 = m/1 + m \cdot R \qquad (5)$$

Mit Hilfe dieser Beziehung wird für einen vorgegebenen höchstzulässigen Grenzwert m der Wert R3 des weiteren Widerstandes 30 festgelegt.

Da U3 den Wert des jeweils größeren Meßsignals besitzt, gilt auch für den Fall, daß U2 das größere Meßsignal ist, die Gleichung (5) für die Bemessung des weiteren Widerstandes 30.

Die Reihenschaltung des Hilfswiderstandes 14 und des Feldeffekttransistors 33, die parallel zum weiteren Widerstand 30 liegt, bewirkt bei Ansteuerung des Gate des Feldeffekttransistors 33 eine Veränderung der Bewertung des Signals U3. Nach dem Ansprechen der Grenzwertstufe 11 wird der Feldeffekttransistor 33 in seiner Source-Drain-Strecke leitend und somit eine Parallelschaltung des Hilfswiderstandes 14 zum weiteren Widerstand 30 der Bewertungsschaltung 6 wirksam ; dies hat eine Verminderung des höchstzulässigen Grenzwertes zur Folge. Damit ist sichergestellt, daß die Grenzwertstufe 11 nach dem Ansprechen auch bei geringfügigen Schwankungen des Verhältnisses der Werte der Meßsignale in ihrem Zustand verharrt ; das Signal am Ausgang 17 also erhalten bleibt.

Die erfindungsgemäße Schaltungsanordnung gewährleistet somit eine sichere und stabile Überwachung des Verhältnisses der Werte zweier elektrischer Meßsignale auf einem beliebig vorgebbaren höchstzulässigen Grenzwert hin.

**Ansprüche**

1. Schaltungsanordnung zur Überwachung des Verhältnisses der Werte zweier elektrischer Meßsignale auf einen vorgegebenen höchstzulässigen Grenzwert mit einer Grenzwertstufe (11), der eingangsseitig eine mit den zwei Meßsignalen direkt beaufschlagte Bewertungsschaltung (6) vorgeordnet ist, gekennzeichnet durch folgende Merkmale :

a) die Schaltungsanordnung enthält ein Übertragungsnetzwerk (1), dem eingangsseitig die zwei Meßsignale zugeführt werden und das auf seinen Ausgang (4) nur dasjenige Meßsignal überträgt, welches den jeweils größeren Wert aufweist, und

b) die Bewertungsschaltung (6) ist eingangsseitig auch mit dem Ausgang (4) des Übertragungsnetzwerkes (1) verbunden und bewertet die Meßsignale (U1, U2) und das Signal am Ausgang (4) des Übertragungsnetzwerkes (1) derart, daß bei dem vorgegebenen höchstzulässigen Grenzwert des Verhältnisses der Werte der Meßsignale (U1, U2) die Summe aller bewerteter Signale (U1, U2, U3) eine vorbestimmte Größe hat.

2. Schaltungsanordnung nach Anspruch 1 gekennzeichnet durch folgende Merkmale :

c) der Eingang (10) der Grenzwertstufe (11) liegt über einen Widerstand (28) der Bewertungsschaltung (6) an dem einen Meßsignal und über einen zweiten Widerstand (29) der Bewertungsschaltung (6) an dem zweiten Meßsignal und ist über einen weiteren Widerstand (30) der Bewertungsschaltung (6) mit dem Ausgang (4) des Übertragungsnetzwerkes (1) verbunden,

d) der weitere Widerstand (30) ist gemäß der Gleichung

$$R3 = m/1 + m \cdot R$$

bemessen, wobei R den Wert sowohl des ersten als auch des zweiten Widerstandes und m den vorgegebenen höchstzulässigen Grenzwert des Verhältnisses des Wertes des jeweils größeren Meßsignals zu dem des jeweils kleineren Meßsignals bezeichnet,

e) die vorbestimmte Größe der Summe aller bewerteter Signale ist Null.

3. Schaltungsanordnung nach Anspruch 1 und 2 gekennzeichnet durch folgende Merkmale :

f) dem weiteren Widerstand (30) der Bewertungsschaltung (6) liegt eine Reihenschaltung von einem Hilfswiderstand (14) und einer Schalteinrichtung (15) parallel,

g) der Steuereingang (16) der Schalteinrichtung (15) ist mit dem Ausgang (17) der Grenzwertstufe (11) verbunden.

4. Schaltungsanordnung nach Anspruch 3 gekennzeichnet durch folgendes Merkmal :

h) die Schalteinrichtung (15) enthält einen Transistor (33).

5. Schaltungsanordnung nach einem der vorangehenden Ansprüche, gekennzeichnet durch folgende Merkmale :

i) im Übertragungsnetzwerk (1) ist für jedes Meßsignal ein Operationsverstärker (20, 21) vorgesehen,

k) die Operationsverstärker (20, 21) sind gleich ausgebildet und

l) Rückkopplungsnetzwerke (22, 23) der Operationsverstärker (20, 21) sind gleich ausgeführt und mit ihren Ausgängen zusammengeschaltet.

## Claims

1. A circuit arrangement for monitoring the ratio of the values of two electrical measuring signals relative to a pre-determined maximum permissible limit value, having a limit value stage (11) which at the input end is preceded by a rating circuit (6) to which are directly fed two measuring signals, characterised by the following features :

a) the circuit arrangement comprises a transmission network (1) to the inputs of which the two measuring signals are applied and which only transmits onto its output (4) that measuring signal which has the higher value in each case, and

b) the rating circuit (6) is also connected to the output (4) of the transmission network (1) at the input end, and rates both the measuring signals ($U_1$, $U_2$) and the signal at the output (4) of the transmission network (1) in such manner that in the case of the predetermined maximum permissible limit value of the ratio of the values of the measuring signals ($U_1$, $U_2$), the sum of all analysed signals ($U_1$, $U_2$, $U_3$) has a predetermined magnitude.

2. A circuit arrangement as claimed in Claim 1, characterised by the following features :

c) the input (10) of the limit value stage (11) is connected via a resistor (28) of the rating circuit (6) to the one measuring signal and via a second resistor (29) of the rating circuit (6) to the second measuring signal and is connected via a further resistor (30) of the rating circuit (6) to the output (4) of the transmission network (1),

d) the further resistor (30) is dimensioned in accordance with the equation

$$R3 = m/1 + m \cdot R$$

where R represents the value both of the first and of the second resistor and m represents the predetermined maximum permissible limit value of the ratio of the value of the higher measuring signal to that of the smaller measuring value,

e) the predetermined magnitude of the sum of all analysed signals is nil.

3. A circuit arrangement as claimed in Claim 1 and 2, characterised by the following features :

f) a series connection of an auxiliary resistor (14) and a switching device (15) arranged parallel to the further resistor (30) of the rating device (6),

g) the control input (16) of the switching device (15) is connected to the output (17) of the limit value stage (11).

4. A circuit arrangement as claimed in Claim 3, characterised by the following feature :

h) the switching device (15) comprises a transistor (33).

5. A circuit arrangement as claimed in one of the preceding Claims, characterised by the following features :

i) in the transmission network (1), there is arranged an operational amplifier (20, 21) for each measuring signal,

k) the operational amplifiers (20, 21) are identical and

l) feedback networks (22, 23) of the operational amplifiers (20, 21) are identical and mutually connected by means of their outputs.

## Revendications

1. Circuit pour surveiller le rapport des valeurs de deux signaux de mesure électriques en ce qui concerne une valeur limite maximale admissible prédéterminée, comportant un étage de valeur limite (11) en amont duquel est monté, côté entrée, un circuit d'évaluation (6) recevant directement les deux signaux de mesure, caractérisé par les caractéristiques suivantes :

a) le circuit comprend un réseau de transmission (1) auquel les deux signaux de mesure sont appliqués, côté entrée, et qui transmet sur sa sortie (5) uniquement le signal de mesure qui présente respectivement la valeur plus élevée, et

b) le circuit d'évaluation (6) est également relié, côté entrée, à la sortie (4) du réseau de transmission (1) et évalue les signaux de mesure (U1, U2) et le signal à la sortie (4) du réseau de transmission (1) de manière que la somme de tous les signaux évalués (U1, U2, U3) ait une valeur prédéterminée dans le cas de la valeur limite maximale admissible prédéterminée du rapport des valeurs des signaux de mesure (U1, U2).

2. Circuit suivant la revendication 1 caractérisé par les caractéristiques suivantes :

c) l'entrée (10) de l'étage de valeur limite (11) reçoit un des signaux de mesure, par l'intermédiaire d'une résistance (28) du circuit d'évaluation (6), et le second signal de mesure, par l'intermédiaire d'une seconde résistance (29) du circuit d'évaluation (6), et est reliée à la sortie (4) du réseau de transmission (1), par l'intermédiaire d'une autre résistance (30) du circuit d'évaluation (6),

d) l'autre résistance (30) est dimensionnée suivant l'équation

$$R3 = m/1 + m \cdot R$$

R étant la valeur aussi bien de la première que de la seconde résistance et m étant la valeur limite maximale admissible prédéterminée du rapport de la valeur du signal de mesure respectivement plus élevé à la valeur du signal de mesure respectivement plus faible,

e) la grandeur prédéterminée de la somme de tous les signaux évalués est nulle.

3. Circuit suivant la revendication 1 et 2, caractérisé par les caractéristiques suivantes :

f) en parallèle sur l'autre résistance (30) du circuit d'évaluation (6) est monté un circuit série comprenant une résistance auxiliaire (14) et un dispositif de commutation (15),

g) l'entrée de commande (16) du dispositif de commutation (15) est reliée à la sortie (17) de l'étage de valeur limite (11).

4. Circuit suivant la revendication 3, caractérisé par la caractéristique suivante :

h) le dispositif de commutation (15) comprend un transistor (33).

5. Circuit suivant l'une des revendications précédentes, caractérisé par les caractéristiques suivantes :

i) dans le réseau de transmission (1) est prévu un amplificateur opérationnel (20, 21) pour chaque signal de mesure,

k) les amplificateurs opérationnels (20, 21) ont la même constitution, et

l) les circuits de réaction (22, 23) des amplificateurs opérationnels (20, 21) ont la même constitution et sont reliés entre eux par leurs sorties.

FIG 1

FIG 2